# EUROPEAN PATENT SPECIFICATION

(11) **EP 3 270 436 B1**
(45) Date of publication and mention of the grant of the patent: **06.10.2021**
(21) Application number: 15831212.4
(22) Date of filing: 28.07.2015
(51) Int. Cl.: H01L 27/32, H01L 51/56, H01L 51/00

(54) **METHOD FOR PREPARING A DISPLAY SUBSTRATE**
HERSTELLUNGSVERFAHREN EINES ANZEIGESUBSTRATS
PROCÉDÉ DE PRÉPARATION D'UN SUBSTRAT D'AFFICHAGE

(30) Priority: 12.03.2015 CN 201510108888
(43) Date of publication of application: 17.01.2018
(73) Proprietor: BOE Technology Group Co., Ltd., Beijing 100015 (CN)
(72) Inventor: SHI, Shoulei, Beijing 100176 (CN); LIU, Ze, Beijing 100176 (CN)
(74) Representative: Brötz, Helmut
(86) International application number: PCT/CN2015/085301
(87) International publication number: WO 2016/141665

(56) References cited:
- EP-A1- 2 254 394
- EP-A2- 2 731 139
- CN-A- 1 258 428
- CN-A- 103 715 221
- CN-A- 104 659 287
- JP-A- 2002 006 129
- US-A1- 2007 066 078
- US-A1- 2010 102 715
- US-B1- 6 861 377
- None

## Description

### TECHNICAL FIELD

Embodiments of the present invention relate to a method for preparing a display substrate.

### BACKGROUND ART

Over recent years, researchers have been attempting to apply ink-jet printing technology to the preparation of planar functional materials, such as the preparation of organic material functional layers of an organic electroluminescent light-emitting diode display, the preparation of a color filter layer of a liquid crystal display and the like. It is generally required to prepare a pixel defining layer in a display substrate.

EP2254394 discloses an organic EL display panel and manufacturing method thereof. EP2731139 discloses a light-emitting display backplane, display device and manufacturing method of pixel define layer. JP2002-6129 dislcoses an optical element (a color filter), manufacturing an optical element, and liquid crystal display device. US2007/0066078 discloses a method of producing a substrate having areas of different hydrophilicity and/or oleophilicity on the same surface. US6861377 discloses a surface treatment method, surface-treated substrate, a method for forming film pattern, a method for making electro-optical device, electro-optical device, and an electronic apparatus.

### SUMMARY OF THE INVENTION

It is an object of the present invention to provide a method for preparing a display substrate, which may enable the lyophobic performance of the pixel defining layer to be maintained for a long time.

The object is achieved by the features of claim 1, and further embodiments are defined by the respective dependent claims.

### BRIEF DESCRIPTION OF THE DRAWINGS

In order to illustrate the technical solutions of the embodiments of the present invention more clearly, the drawings of the embodiments are simply described below. Apparently, the drawings described below relate to only some embodiments of the present invention and are not limitative of the present invention.
Figure 1 is a schematic top view of an organic electroluminescent light-emitting diode display.
Figure 2 is a schematic structural view of a pixel defining layer.
Figures 3a-3b are schematic view I of a process for preparing a display substrate comprising forming a pixel defining layer on a substrate according to an embodiment not forming part of the present invention.
Figure 4 is a schematic view of the principle for self-assembling fluorooctyl trichlorosilane on a first pattern of inorganic material according to an embodiment of the present invention.
Figures 5a-5b are schematic view II of a process for preparing a pixel defining layer according to an embodiment of the present invention.
Figure 6 is a schematic view of a process for forming a photosensitive organic resin layer between a basic pattern of a pixel defining layer according to an embodiment of the present invention.
Figures 7a-7e are schematic view III of the process for preparing a pixel defining layer according to an embodiment of the present invention.
Figures 8a-8d are schematic views of a process for preparing a display substrate for organic light-emitting diode (OLED) according to an embodiment of the present invention.

Description of reference signs:
01 - pixel region; 02 - non-pixel region; 20 - pixel defining layer; 100 - substrate; 200 - basic pattern of pixel defining layer; 200a - first pattern; 200b - second pattern; 210 - fluorinated monomolecular layer; 300 - (photosensitive) organic resin layer; 300a - second film of photosensitive organic resin material; 400 - third film of negative photosensitive organic resin material; 400a - third pattern; 500 - fourth film of inorganic material; 600 - fifth film of negative photosensitive organic resin material; 600a - fifth pattern; 700 - first electrode; 800 - organic material functional layer; 900 - second electrode layer.

### DETAILED DESCRIPTION

To make clearer the objects, technical solutions and advantages of the embodiments of the present invention, a clear and full description of the technical solutions of the embodiments of the present invention will be made with reference to the accompanying drawings of the embodiments, some of which are embodiments of the present invention. Obviously, the embodiments described are merely part of rather than all of the embodiments of the present invention. Based on the embodiments of the present invention described, all the other embodiments acquired by a person of ordinary skill in the art, without any creative labor, fall within the scope of protection of the present invention as defined by the appended claims.

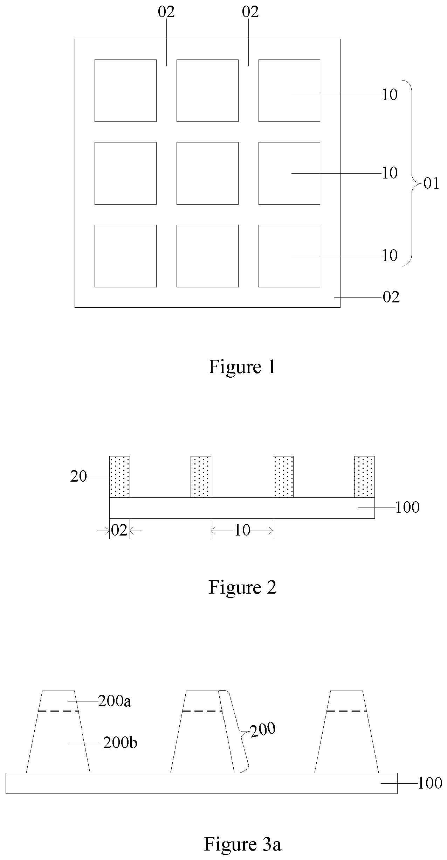

Taking an organic electroluminescent light-emitting diode display (OLED) as an example, as shown in Figure 1 and Figure 2, the organic electroluminescent light-emitting diode comprises a pixel region 01 and a non-pixel region 02, the pixel region 01 consisting of a plurality of pixels 10, wherein each pixel 10 comprises an anode, an organic material functional layer and a cathode disposed sequentially on a substrate 100 (not shown in Figure 1 and Figure 2). Upon forming the organic material functional layer on the anode by ink-jet printing, due to the flowability of ink and in order to reduce overflow of the ink that is ink-jet printed to the adjacent pixel 10, a pixel defining layer 20 is typically provided in the non-pixel region 02 to form a plurality of spaces surrounding each pixel 10, the ink of the organic material functional layer ink-jet printed being sprayed in the above surrounding spaces by ink-jet printing, i.e., being sprayed on the anode surface.

The pixel defining layer 20 consists of a basic pattern of the pixel defining layer formed on the substrate 100. In order to achieve lyophobicity of the pixel defining layer 20, currently the most conventional lyophobic treatment method is to subject the above basic pattern of the pixel defining layer to a fluorine-containing plasma treatment. However, due to the characteristics of plasma, its performance generally cannot be held for a long time. As such, ineffectiveness may be caused upon carrying out a preparation process for a long time or an annealing process at high temperatures.

Embodiments not forming part of the present invention provide a method for preparing a pixel defining layer, comprising:
S01. as shown in Figure 3a, forming a basic pattern 200 of the pixel defining layer on a substrate 100; the basic pattern 200 of the pixel defining layer comprises a first pattern 200a of inorganic material, the first pattern 200a being a top part of the basic pattern 200 of the pixel defining layer.

That is, the basic pattern 200 of the pixel defining layer further comprises other patterns in addition to the first pattern 200a, the first pattern being located on or above the other patterns.

"The basic pattern 200 of the pixel defining layer comprises a first pattern 200a of inorganic material, the first pattern 200a being a top part of the basic pattern 200 of the pixel defining layer" may be that the basic pattern 200 of the pixel defining layer further comprises a second pattern 200b of inorganic material in addition to the first pattern 200a of inorganic material, the first pattern 200a being located on or above the second pattern 200b.

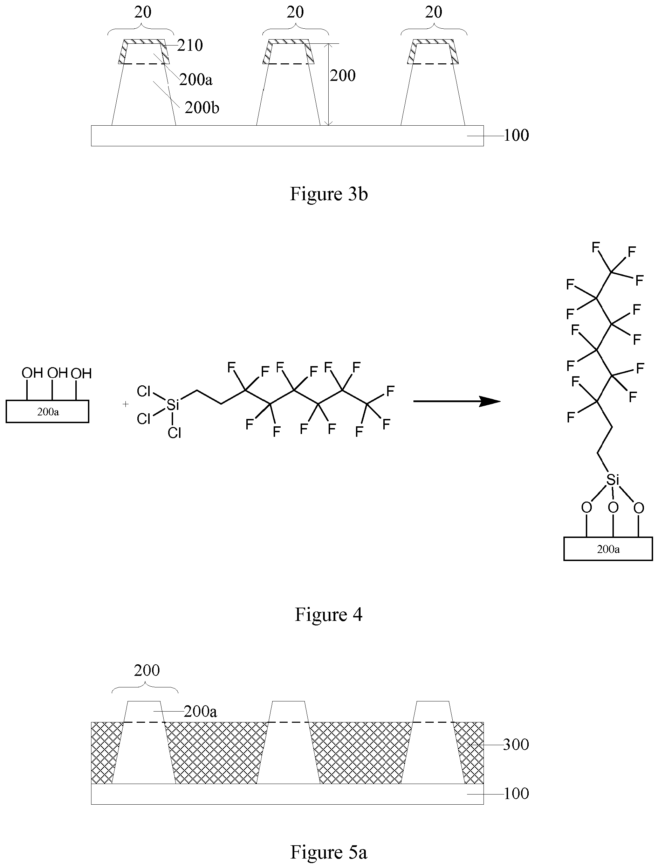

Herein, under the circumstance that the first pattern 200a and the second pattern 200b of the basic pattern 200 of the pixel defining layer have a same material, the basic pattern 200 of the pixel defining layer can be formed by a same inorganic material film, i.e., a thickness of the inorganic material film of the layer is a sum of the thicknesses of the first pattern 200a and the thicknesses of the second pattern 200b. In this case, distinguishing between the first pattern 200a and the second pattern 200b is merely for subsequently describing the structure of the fluorinated monomolecular layer 210 in a convenient way. The dash lines that distinguish between the first pattern 200a and the second pattern 200b in Figure 3a and Figure 3b actually do not exist.

Of course, under the circumstance that the first pattern 200a and the second pattern 200b of the basic pattern 200 of the pixel defining layer have a same material, the basic pattern 200 of the pixel defining layer can also be formed by two inorganic material films, i.e., one of the inorganic material films is used for forming the first pattern 200a and the other inorganic material film is used for forming the second pattern 200b, which may specifically depends upon actual conditions and no limitation will be made herein.

Alternatively, "the basic pattern 200 of the pixel defining layer comprises a first pattern 200a of inorganic material, the first pattern 200a being a top part of the basic pattern 200 of the pixel defining layer" may also be that the basic pattern 200 of the pixel defining layer further comprises, in addition to the first pattern 200a of inorganic material, a third pattern of other material such as organic material, the first pattern 200a being located on or above the third pattern. In this case, a difference between the second pattern 200b and the third pattern merely lies in the material.

Of course, embodiments do not limit to that in addition to the first pattern 200a of inorganic material, the basic pattern 200 of the pixel defining layer comprises only a third pattern, but the basic pattern 200 of the pixel defining layer also comprises other patterns as long as these patterns can constitute the basic pattern 200 of the pixel defining layer, where the first pattern 200a is the top part thereof.

On the basis of the above circumstances, settings may be made depending upon actual conditions and no limitation will be made herein.

S02. As shown in Figure 3b, subjecting the first pattern 200a to a surface treatment with a self-assembled monomolecular layer to form a fluorinated monomolecular layer 210 on a surface of the first pattern 200a, and thus form the pixel defining layer 20.

Herein, a person skilled in the art should know that after self-assembling, the fluorinated monomolecular layer 210 is connected to the first pattern 200a via a covalent bond.

According to the invention, fluorosilane being fluorooctyl trichlorosilane is selected as a self-assembled lyophobic material to subject the first pattern 200a to a self-assembled surface treatment; the principle for self-assembling the material is as shown in Figure 4.

The fluorooctyl trichlorosilane has the following formula:

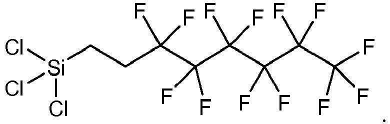

According to the invention, the substrate on which the first pattern 200a is formed is placed in a fluorooctyl trichlorosilane atmosphere to be held for 2 hours at a temperature ranging from 100-250°C.

It shall be noted that firstly, the above substrate 100 has no limitation, and may be either a substrate on which a corresponding pattern layer is formed or a base substrate on which no pattern layer is formed.

Secondly, the thickness of the first pattern 200a has no limitation, and may be set depending upon the actual condition.

Thirdly, because the pixel defining layer in the prior art is not additionally provided with the fluorinated monomolecular layer 210, the basic pattern 200 of the pixel defining layer in the embodiments of the present invention is substantively the pixel defining layer as described in the prior art.

Embodiments of the present invention provide a method for preparing a display substrate as recited in claim 1. Because the self-assembled fluorinated monomolecular layer 210 is connected to the first pattern 200a via a covalent bond, placement over a long period of time, a general cleaning step (other than plasma), and processes such as annealing will not affect the lyophobic performance thereof. Therefore, the lyophobic performance of the pixel defining layer 20 formed by such a method can be maintained for a long time without worrying about out-of-service thereof. In addition, the contact angle of the self-assembled fluorinated monomolecular layer 210 may achieve up to 110°C.

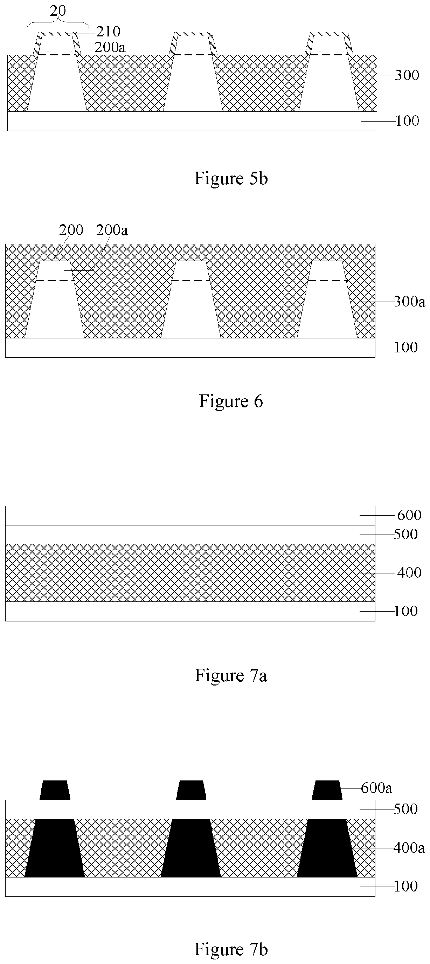

According to the invention, the above S02 specifically comprises the steps of:
S201. As shown in Figure 5a, forming a photosensitive organic resin layer 300 between the basic pattern 200 of the pixel defining layer, the photosensitive organic resin layer 300 exposing the first pattern 200a.
S202. Subjecting the first pattern 200a exposed to a surface treatment with a self-assembled monomolecular layer.
S203. As shown in Figure 5b, forming a fluorinated monomolecular layer 210 on the surface of the first pattern 200a, to form the pixel defining layer 20.
S204. Removing the photosensitive organic resin layer 300 to form the structure as shown in Figure 3b.

In one aspect, forming the photosensitive organic resin layer 300 in regions other than the region in which the basic pattern 200 of the pixel defining layer is located may protect the pattern layers of other regions upon forming the fluorinated monomolecular layer 210; besides, by setting the thickness of the photosensitive organic resin layer 300, the thickness of the first pattern 200a can be determined so as to determine the range for forming the fluorinated mono molecular layer 210.

In another aspect, compared with other non-photosensitive organic materials, the photosensitive organic resin material employed in the embodiments of the present invention can simplify the process upon forming the organic resin layer 300.

On this basis, explanation may be made based on the following two conditions. The first condition is as follows.

In some embodiments, under the circumstance that the requirement for the height of the basic pattern 200 of the pixel defining layer is not high, an inorganic material may be directly employed to form the basic pattern 200 of the pixel defining layer, i.e., the above S01 may specifically comprise the steps of:
S101. forming a first film of inorganic material on a substrate 100.
S102. subjecting the first film to a patterning process to form the basic pattern 200 of the pixel defining layer that is comprised of the first pattern 200a and a second pattern 200b.

That is, the first pattern 200a and the second pattern 200b are formed integrally.

It shall be noted that the basic pattern 200 of the pixel defining layer formed by steps S101-S102 actually does not contain the dash line for distinguishing the first pattern 200a and the second pattern 200b in Figure 3a. Dash lines are provided in the drawings of the present invention mainly for the purpose of facilitating to describe the range for forming the fluorinated monomolecular layer 210.

Under this circumstance, in some embodiments, the above S201 may specifically comprise the steps of:
S201a. As shown in Figure 6, forming a second film 300a of the photosensitive organic resin material on the substrate on which the basic pattern 200 of the pixel defining layer is formed, the second film 300a covering the basic pattern 200 of the pixel defining layer.

Herein, the photosensitive organic resin material may be, for example, an organic photoresist.

S201b. Etching the second film 300a with plasma to expose the first pattern 200a such that the second film between the basic pattern 200 of the pixel defining layer (that is, the second film in the pixel region defined by the pixel defining layer) is formed into the photosensitive organic resin layer 300 as shown in Figure 5a.

Herein, by controlling the time of plasma etching, the height of the photosensitive organic resin layer 300 can be controlled, thereby determining the height of the first pattern 200a.

As such, compared with directly forming an organic resin layer 300, damage to pattern layers in other regions during subsequent self-assembling caused by non-uniform deposition upon forming an organic resin layer 300 may be avoided.

The second condition is as follows:
In some embodiments, under the circumstance that the requirement for the height of the basic pattern 200 of the pixel defining layer is strict, the basic pattern 200 of the pixel defining layer is formed using an organic material and an inorganic material, i.e., the above step S01 may specifically be as follows: forming the basic pattern 200 of the pixel defining layer that is comprised of the first pattern 200a and a third pattern of organic material on a substrate 100, wherein the first pattern 200a is located on or above the third pattern.

In some embodiments, forming the basic pattern 200 of the pixel defining layer that is comprised of the first pattern 200a and a third pattern of organic material as described above may be specifically achieved by the following steps:
S111. As shown in Figure 7a, sequentially forming a third film 400 of negative photosensitive organic resin material, a fourth film 500 of inorganic material and a fifth film 600 of negative photosensitive organic resin material on a substrate 100.

In some embodiments, a negative photosensitive organic resin material is employed for the material of the third film 400 such that the third pattern finally formed is the cured portion after exposure, i.e., the portion retained on the substrate is the cured portion and the portion not retained on the substrate is the uncured portion. As such, during subsequent cleaning and use, the structure thereof can be well maintained and good stability may be obtained.

S112. As shown in Figure 7b, exposing the substrate on which the third film 400, the fourth film 500 and the fifth film 600 are formed by using an ordinary mask such that the cured portion in the third film 400 forms the third pattern 400a and the cured portion in the fifth film 600 forms a fifth pattern 600a, and removing the uncured portion in the fifth film after development.

Herein, under the circumstance of exposing the substrate on which the third film 400, the fourth film 500 and the fifth film 600 are formed by using an ordinary mask, the cured portion in the third film 400 forming the third pattern 400a, the cured portion, i.e., the fifth pattern 600a, in the fifth film 600 is necessarily located on top of the third pattern 400a. Therefore, as long as the third pattern 400a is defined, the position of the fifth pattern 600a is correspondingly defined.

The exposed region of the substrate can be controlled by controlling the position of the projection of the opening of the mask in the substrate.

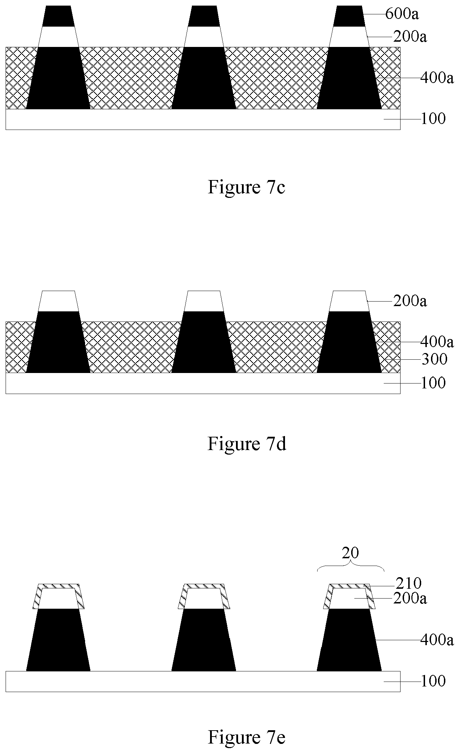

S113. As shown in Figure 7c, etching the fourth film 500 using the fifth pattern 600a as a mask to form the first pattern 200a, wherein the third pattern 400a and the first pattern 200a constitute the basic pattern 200 of the pixel defining layer.

Afterwards, as shown in Figure 7d, removing the fifth pattern 600a such that the uncured portion in the third pattern 400 is formed into the photosensitive organic resin layer 300.

As such, the basic pattern 200 of the pixel defining layer can be formed by using a mask only once, and a photosensitive organic resin layer 300 between the basic pattern 200 of the pixel defining layer (that is, a photosensitive organic resin layer 300 in the pixel region defined by the pixel defining layer) is formed.

In this case, in some embodiments, a fluorinated monomolecular layer 210 is formed on the surface of the first pattern 200a to form the pixel defining layer 20. Then, the photosensitive organic resin layer 300 is removed to form the structure as shown in Figure 7e.

On the above basis, fluorosilane may be employed to subject the first pattern 200a to the surface treatment with the self-assembled monomolecular layer. On this basis, prior to subjecting the first pattern 200a to the surface treatment with the self-assembled monomolecular layer with the fluorosilane, the method further comprises: subjecting the first pattern 200a to a hydroxylation treatment.

After the hydroxylation treatment, the first pattern 200a may react with a silane more easily.

Embodiments of a device obtained by the method of the present invention further provide a pixel defining layer 20, as shown in Figure 3b and Figure 7e, the pixel defining layer 20 comprising: a basic pattern 200 of the pixel defining layer comprising a first pattern 200a of inorganic material, the first pattern 200a being the top part of the basic pattern 200 of the pixel defining layer; further comprising: a fluorinated monomolecular layer 210 self-assembled on a surface of the first pattern.

In some embodiments, as shown in Figure 3b, the basic pattern 200 of the pixel defining layer may further comprise a second pattern 200b of inorganic material in addition to the first pattern 200a of inorganic material. Moreover, the first pattern 200a is located on or above the second patter 200b. Herein, distinguishing the first pattern 200a from the second pattern 200b is merely for facilitating to subsequently describe the structure of the fluorinated monomolecular layer 210. The dash lines that distinguish the first pattern 200a from the second pattern 200b in Figure 3b actually do not exist.

As shown in Figure 7e, in addition to the first pattern 200a of inorganic material, the basic pattern 200 of the pixel defining layer further comprises a third pattern 400a of organic material, the first pattern 200a being located on or above the third pattern 400a.

Embodiments of a device not forming part of the present invention further provide a pixel defining layer 20, comprising: a basic pattern 200 of the pixel defining layer comprising a first pattern 200a of inorganic material, the first pattern 200a being the top part of the basic pattern 200 of the pixel defining layer; and further comprising: a fluorinated monomolecular layer 210 self-assembled on the surface of the first pattern. Because the self-assembled fluorinated monomolecular layer 210 is connected to the first pattern 200a via a covalent bond, placement over a long period of time, a general cleaning step (other than plasma), and processes such as annealing will not affect the lyophobic performance thereof. Therefore, the lyophobic performance of the pixel defining layer 20 formed by such a method can be maintained for a long time without worrying about out-of-service thereof.

In some embodiments, under the circumstance that the requirement for the height of the basic pattern 200 of the pixel defining layer is not strict, as shown in Figure 3b, the basic pattern 200 of the pixel defining layer is formed by directly using an inorganic material, i.e., the basic pattern 200 of the pixel defining layer comprises the first pattern 200a of inorganic material and the second pattern 200b of inorganic material, and the first pattern 200a and the second pattern 200b are formed integrally. That is, the first pattern 200a and the second pattern 200b are formed by subjecting one film layer to a patterning process.

It shall be noted that the dash lines that distinguish between the first pattern 200a and the second pattern 200b in Figure 3b actually do not exist. Dash lines are provided in the figures of the present invention mainly for the purpose of facilitating to describe the range for forming the fluorinated monomolecular layer 210.

In some embodiments, under the circumstance that the requirement for the height of the basic pattern 200 of the pixel defining layer is strict, as shown in Figure 7e, the basic pattern 200 of the pixel defining layer is formed by using an organic material and an inorganic material, i.e., the basic pattern 200 of the pixel defining layer comprises the first pattern 200a of inorganic material and a third pattern 400a of organic material.

In some embodiments, the material of the third pattern 400a is a photosensitive organic resin material after being cured.

Embodiments not forming part of the present invention further provide a display substrate, comprising the above pixel defining layer 20.

The display substrate may be a display substrate which can form corresponding pattern layers by ink-jet printing, such as an array substrate for OLED or a color filter substrate for a liquid crystal display.

Embodiments not forming part of the present invention further provide a display apparatus, comprising the above display substrate.

The display apparatus may be a display device such as a liquid crystal display, electronic paper, OLED, a polymer light-emitting diode (PLED), etc., and any product or component having display function such as a TV set, a digital camera, a mobile phone or a tablet computer including these display devices.

Embodiments of the present invention provide a method for preparing a display substrate, comprising forming a pixel defining layer 20 on a substrate 100, wherein the method for preparing a pixel defining layer 20 is the above method for preparing a pixel defining layer 20.

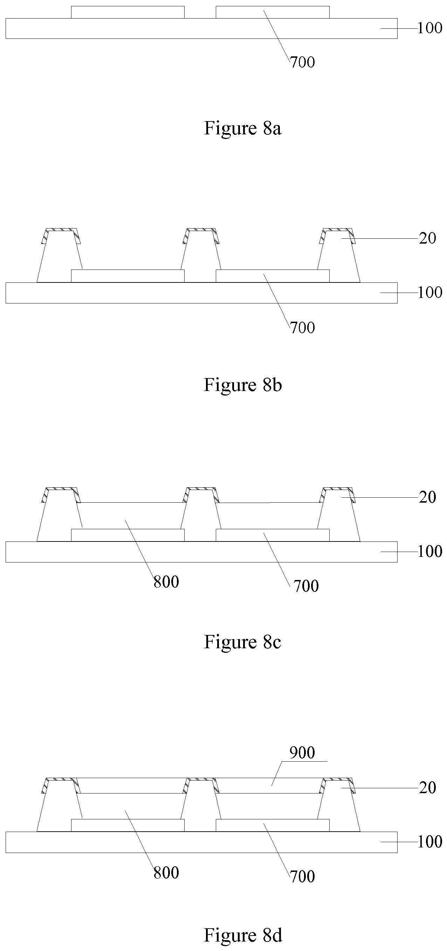

Illustratively, taking a display substrate for OLED as an example, the preparation method comprises:
S301. As shown in Figure 8a, forming a first electrode 700 on the pixel region of the substrate 100 by a patterning process.

The first electrode 700 generally can be an anode, or sometimes a cathode.

S302. As shown in Figure 8b, forming a pixel defining layer 20 on the non-pixel region of the substrate 100.

The method for preparing a pixel defining layer 20 usually employs the above method for preparing a pixel defining layer 20, and no further detail will be given herein.

S303. As shown in Figure 8c, forming an organic material functional layer 800 on the first electrode in the pixel region defined by the pixel defining layer 20.

As to the organic material functional layer 800, it may at least comprise a light-emitting layer, and may further comprise an electron transport layer and a hole transport layer. On this basis, in order to improve the efficiency of injecting electrons and holes to a light-emitting layer, the organic material functional layer may further comprise an electron injection layer disposed between the cathode and the electron transport layer, and a hole injection layer disposed between the hole transport layer and the anode.

The organic material functional layer 800 may be formed by ink-jet printing.

S303. As shown in Figure 8d, forming a second electrode layer 900 on the organic material functional layer 800.

The second electrode layer 900 generally can be a cathode, or sometimes an anode.

The above are merely exemplary embodiments of the present invention, and are not intended to limit the scope of protection of the present invention, which is defined by the appended claims.

The present application claims the priority of the Chinese patent application No. 201510108888.5 submitted on March 12, 2015.

## Claims

1. A method for preparing a display substrate comprising forming a pixel defining layer (20) on a substrate (100), wherein a method for preparing the pixel defining layer (20) comprises:
forming a basic pattern (200) of the pixel defining layer on the substrate (100); the basic pattern (200) of the pixel defining layer comprises a first pattern (200a) of inorganic material, the first pattern (200a) being a top part of the basic pattern (200) of the pixel defining layer; and
subjecting the first pattern (200a) to a surface treatment with a self-assembled monomolecular layer to form a fluorinated monomolecular layer (210) on a surface of the first pattern (200a), and thus form the pixel defining layer (20);
wherein subjecting the first pattern (200a) to a surface treatment with the self-assembled monomolecular layer comprises:
forming a photosensitive organic resin layer (300) between the basic pattern (200) of the pixel defining layer, the photosensitive organic resin layer (300) exposing the first pattern;
selecting fluorooctyl trichlorosilane as a self-assembled lyophobic material to subject the first pattern (200a) to a self-assembled surface treatment in a fluorooctyl trichlorosilane atmosphere to be held for 2 hours at a temperature ranging from 100-250°C to form the fluorinated monomolecular layer (210), wherein the fluorinated monomolecular layer (210) is connected to the first pattern (200a) via a covalent bond, and the fluorooctyl trichlorosilane has a formula: 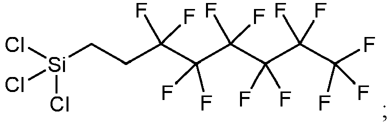 and
removing the photosensitive organic resin layer (300) after the fluorinated monomolecular layer (210) has been formed on the surface of the first pattern (200a).

2. The method of claim 1, wherein forming the basic pattern (200) of the pixel defining layer on the substrate comprises:
forming a first film of inorganic material on the substrate (100); and
subjecting the first film to a patterning process to form the basic pattern (200) of the pixel defining layer that is comprised of the first pattern (200a) and a second pattern (200b).

3. The method of claim 2, wherein forming the photosensitive organic resin layer (300) between the basic pattern (200) of the pixel defining layer, the photosensitive organic resin layer (300) exposing the first pattern (200a) comprises:
forming a second film (300a) of photosensitive organic resin material on the substrate (100) on which the basic pattern (200) of the pixel defining layer is formed, the second film (300a) covering the basic pattern (200) of the pixel defining layer; and
etching the second film (300a) by plasma to expose the first pattern (200a) such that the second film (300a) between the basic pattern (200) of the pixel defining layer is formed into the photosensitive organic resin layer (300).

4. The method of claim 1, wherein forming the basic pattern (200) of the pixel defining layer on the substrate (100) comprises:
forming the basic pattern (200) of the pixel defining layer that is comprised of the first pattern (200a) and a third pattern (400a) of organic material on the substrate (100).

5. The method of claim 4, wherein forming the basic pattern (200) of the pixel defining layer that is comprised of the first pattern (200a) and the third pattern (400a) of organic material on the substrate (100) comprises:
sequentially forming a third film (400) of negative photosensitive organic resin material, a fourth film (500) of inorganic material and a fifth film (600) of negative photosensitive organic resin material on the substrate (100);
exposing the substrate (100) on which the third film (400), the fourth film (500) and the fifth film (600) are formed by using a mask such that the cured portion in the third film (400) forms the third pattern (400a) and the cured portion in the fifth film (600) forms a fifth pattern (600a), and removing the uncured portion in the fifth film (600) after development; and
etching the fourth film (500) by using the fifth pattern (600a) as another mask to form the first pattern (200a); wherein the third pattern (400a) and the first pattern (200a) constitute the basic pattern (200) of the pixel defining layer;
forming the photosensitive organic resin layer (300) between the basic pattern (200) of the pixel defining layer comprises:
forming the uncured portion in the third film (400) into the photosensitive organic resin layer (300) after removing the fifth pattern (600a).

## Patentansprüche

1. Verfahren zur Herstellung eines Anzeigesubstrats, umfassend das Bilden einer Pixeldefinierungsschicht (20) auf einem Substrat (100), wobei ein Verfahren zur Herstellung der Pixeldefinierungsschicht (20) umfasst:
Bilden eines Basismusters (200) der Pixeldefinierungsschicht auf dem Substrat (100); das Basismuster (200) der Pixeldefinierungsschicht umfasst ein erstes Muster (200a) aus anorganischem Material, das erste Muster (200a) ist ein oberer Teil des Basismusters (200) der Pixeldefinierungsschicht; und
Aussetzen des ersten Musters (200a) einer Oberflächenbehandlung mit einer selbstorganisierten monomolekularen Schicht, um eine fluorierte monomolekulare Schicht (210) auf einer Oberfläche des ersten Musters (200a) zu bilden, und somit die Pixeldefinierungsschicht (20) zu bilden;
wobei das Aussetzen des ersten Musters (200a) einer Oberflächenbehandlung mit der selbstorganisierten monomolekularen Schicht umfasst:
Bilden einer lichtempfindlichen organischen Harzschicht (300) zwischen dem Basismuster (200) der Pixeldefinierungsschicht, wobei die lichtempfindliche organische Harzschicht (300) das erste Muster freilegt;
Auswählen von Fluoroctyl-Trichlorsilan als ein selbstorganisiertes lyophobes Material, um das erste Muster (200) einer selbstorganisierten Oberflächenbehandlung in einer Fluoroctyl-Trichlorsilan-Atmosphäre, die für zwei Stunden bei einem Temperaturbereich von 100 bis 250° zu halten ist, auszusetzen, um die fluorierte monomolekulare Schicht (210) zu bilden, wobei die fluorierte monomolekulare Schicht (210) mit dem ersten Muster (200a) mittels einer kovalenten Bindung verbunden ist, und wobei das Fluoroctyl-Trichlorsilan eine Formel besitzt: 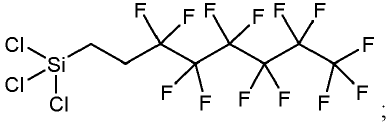 und
Entfernen der lichtempfindlichen organischen Harzschicht (300) nach dem die fluorierte monomolekulare Schicht (200) auf der Oberfläche des ersten Musters (200a) gebildet worden ist.

2. Verfahren gemäß Anspruch 1, wobei das Bilden des Basismusters (200) der Pixeldefinierungsschicht auf dem Substrat umfasst:
Bilden eines ersten Films aus anorganischem Material auf dem Substrat (100); und
Aussetzen des ersten Films einem Bemusterungsprozess, um das Basismusters (200) der Pixeldefinierungsschicht, das aus dem ersten Muster (200a) und dem zweiten Muster (200b) gebildet ist, zu formen.

3. Verfahren gemäß Anspruch 2, wobei das Bilden der lichtempfindlichen organischen Harzschicht (300) zwischen dem Basismuster (200) der Pixeldefinierungsschicht, wobei die lichtempfindliche organische Harzschicht (300) das erste Muster (200a) freilegt, umfasst:
Bilden eines zweiten Films (300a) aus lichtempfindlichem organischem Harzmaterial auf dem Substrat (100), auf welchem das Basismuster (200) der Pixeldefinierungsschicht gebildet ist, wobei der zweite Film (300a) das Basismuster (200) der Pixeldefinierungsschicht bedeckt; und
Ätzen des zweiten Films (300a) mittels Plasma, um das erste Muster (200a) freizulegen, so dass der zweite Film (300a) zwischen dem Basismuster (200) der Pixeldefinierungsschicht in der lichtempfindlichen organischen Harzschicht (300) gebildet wird.

4. Verfahren gemäß Anspruch 1, wobei das Bilden des Basismusters (200) der Pixeldefinierungsschicht auf dem Substrat (100) umfasst:
Bilden des Basismusters (200) der Pixeldefinierungsschicht, das aus dem ersten Muster (200a) und einem dritten Muster (400a) aus organischem Material auf dem Substrat (100) gebildet ist.

5. Verfahren gemäß Anspruch 4, wobei das Bilden des Basismusters (200) der Pixeldefinierungsschicht, das aus dem ersten Muster (200a) und dem dritten Muster (400a) aus organischem Material auf dem Substrat (100) gebildet ist, umfasst:
Sequentielles Bilden eines dritten Films (400) aus negativem lichtempfindlichen organischem Harzmaterial, eines vierten Films (500) aus anorganischem Material und eines fünften Films (600) aus negativem lichtempfindlichen organischem Harzmaterial auf dem Substrat (100);
Freilegen des Substrats (100), auf welchem der dritte Film (400), der vierte Film (500) und der fünfte Film (600) gebildet sind, unter Verwendung einer Maske, so dass der gehärtete Bereich in dem dritten Film (400) das dritte Muster (400a) bildet und der gehärtete Bereich in dem fünften Film (600) ein fünftes Muster (600a) bildet, und Entfernen des ungehärteten Bereiches in dem fünften Film (600) nach der Entwicklung; und
Ätzen des vierten Films (500) mittels Verwendung des fünften Musters (600a) als eine andere Maske zum Bilden des ersten Musters (200a); wobei das dritte Muster (400a) und das erste Muster (200a) das Basismuster (200) der Pixeldefinierungsschicht bilden;
wobei das Bilden der lichtempfindlichen organischen Harzschicht (300) zwischen dem Basismuster (200) der Pixeldefinierungsschicht umfasst:
Bilden des ungehärteten Bereiches in dem dritten Film (400) in der lichtempfindlichen organischen Harzschicht (300) nach Entfernung des fünften Musters (600a).

## Revendications

1. Un procédé de préparation d'un substrat d'affichage comprenant la formation d'une couche de définition de pixels (20) sur un substrat (100), dans lequel un procédé de préparation de la couche de définition de pixels (20) comprend :
la formation d'un motif de base (200) de la couche de définition de pixels sur le substrat (100) ; le motif de base (200) de la couche de définition de pixels comprend un premier motif (200a) de matériau inorganique, le premier motif (200a) étant une partie supérieure du motif de base (200) de la couche de définition de pixels ; et
la soumission du premier motif (200a) à un traitement de surface avec une couche monomoléculaire auto-assemblée pour former une couche monomoléculaire fluorée (210) sur une surface du premier motif (200a), et former ainsi la couche de définition de pixels (20) ;
dans lequel la soumission du premier motif (200a) à un traitement de surface avec la couche monomoléculaire auto-assemblée comprend :
la formation d'une couche de résine organique photosensible (300) entre le motif de base (200) de la couche de définition de pixels, la couche de résine organique photosensible (300) exposant le premier motif ;
la sélection du fluorooctyl trichlorosilane comme matériau lyophobe auto-assemblé pour soumettre le premier motif (200a) à un traitement de surface auto-assemblé dans une atmosphère de fluorooctyl trichlorosilane à maintenir pendant 2 heures à une température dans la plage de 100 à 250°C pour former la couche monomoléculaire fluorée (210), la couche monomoléculaire fluorée (210) étant reliée au premier motif (200a) par une liaison covalente, et le fluorooctyl trichlorosilane ayant une formule : 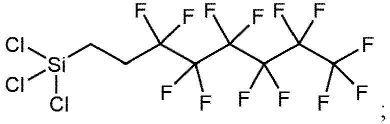 et
l'élimination de la couche de résine organique photosensible (300) après que la couche monomoléculaire fluorée (210) a été formée sur la surface du premier motif (200a).

2. Le procédé de la revendication 1, dans lequel la formation du motif de base (200) de la couche de définition de pixels sur le substrat comprend :
la formation d'un premier film de matériau inorganique sur le substrat (100) ; et
la soumission du premier film à un processus de formation de motifs pour former le motif de base (200) de la couche de définition de pixels qui est constitué du premier motif (200a) et d'un deuxième motif (200b).

3. Le procédé de la revendication 2, dans lequel la formation de la couche de résine organique photosensible (300) entre le motif de base (200) de la couche de définition de pixels, la couche de résine organique photosensible (300) exposant le premier motif (200a) comprend :
la formation d'un deuxième film (300a) de matériau de résine organique photosensible sur le substrat (100) sur lequel est formé le motif de base (200) de la couche de définition de pixels, le deuxième film (300a) couvrant le motif de base (200) de la couche de définition de pixels ; et
la gravure du deuxième film (300a) par plasma pour exposer le premier motif (200a) de manière que le deuxième film (300a) entre le motif de base (200) de la couche de définition de pixels soit formé dans la couche de résine organique photosensible (300).

4. Le procédé de la revendication 1, dans lequel la formation du motif de base (200) de la couche de définition de pixels sur le substrat (100) comprend :
la formation du motif de base (200) de la couche de définition de pixels qui est constitué du premier motif (200a) et d'un troisième motif (400a) de matériau organique sur le substrat (100).

5. Le procédé de la revendication 4, dans lequel la formation du motif de base (200) de la couche de définition de pixels qui est constitué du premier motif (200a) et du troisième motif (400a) de matériau organique sur le substrat (100) comprend :
la formation séquentielle d'un troisième film (400) de matériau de résine organique photosensible négatif, d'un quatrième film (500) de matériau inorganique et d'un cinquième film (600) de matériau de résine organique photosensible négatif sur le substrat (100) ;
l'exposition du substrat (100) sur lequel sont formés le troisième film (400), le quatrième film (500) et le cinquième film (600) sont formés en utilisant un masque de manière que la partie durcie dans le troisième film (400) forme le troisième motif (400a) et la partie durcie dans le cinquième film (600) forme un cinquième motif (600a), et le retrait de la partie non durcie dans le cinquième film (600) après le développement ; et
la gravure du quatrième film (500) en utilisant le cinquième motif (600a) comme autre masque pour former le premier motif (200a) ; dans lequel le troisième motif (400a) et le premier motif (200a) constituent le motif de base (200) de la couche de définition de pixels ;
la formation de la couche de résine organique photosensible (300) entre le motif de base (200) de la couche de définition de pixels comprend :
la formation de la partie non durcie dans le troisième film (400) dans la couche de résine organique photosensible (300) après avoir retiré le cinquième motif (600a).
